(19) Europäisches Patentamt
European Patent Office
Office européen des brevets

(11) **EP 3 031 074 B1**

(12) **FASCICULE DE BREVET EUROPEEN**

(45) Date de publication et mention de la délivrance du brevet:
**02.01.2019 Bulletin 2019/01**

(21) Numéro de dépôt: **14758608.5**

(22) Date de dépôt: **05.08.2014**

(51) Int Cl.:
*H01L 21/268* (2006.01)    *H01L 31/0687* (2012.01)
*H01L 33/00* (2010.01)

(86) Numéro de dépôt international:
**PCT/FR2014/052034**

(87) Numéro de publication internationale:
**WO 2015/019018 (12.02.2015 Gazette 2015/06)**

(54) **PROCÉDÉ, EMPILEMENT ET ENSEMBLE DE SÉPARATION D'UNE STRUCTURE D'UN SUBSTRAT PAR IRRADIATIONS ÉLECTROMAGNÉTIQUES**

VERFAHREN, STAPEL UND ANORDNUNG ZUR TRENNUNG EINER STRUKTUR VON EINEM SUBSTRAT DURCH ELEKTROMAGNETISCHE STRAHLUNG

PROCESS, STACK AND ASSEMBLY FOR SEPARATING A STRUCTURE FROM A SUBSTRATE BY ELECTROMAGNETIC RADIATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.08.2013 FR 1301905**

(43) Date de publication de la demande:
**15.06.2016 Bulletin 2016/24**

(73) Titulaire: **Soitec**
**38190 Bernin (FR)**

(72) Inventeurs:
• **SINQUIN, Yann**
**F-38000 Grenoble (FR)**
• **BETHOUX, Jean-Marc**
**F-38500 La Buisse (FR)**
• **KONONCHUK, Oleg**
**F-38570 Theys (FR)**

(74) Mandataire: **IP Trust**
**2, rue de Clichy**
**75009 Paris (FR)**

(56) Documents cités:
EP-A2- 2 290 706    KR-A- 20110 130 966
US-A1- 2008 099 780    US-A1- 2010 255 344

## Description

La présente invention se rapporte à un procédé de séparation d'une structure d'un substrat par irradiations électromagnétiques, à un empilement de séparation d'une structure d'un substrat par irradiations électromagnétiques, ainsi qu'à un ensemble de séparation.

Un procédé de séparation d'une structure d'un substrat par irradiations électromagnétiques appartenant à un domaine spectral connu de l'état de la technique, notamment des documents US20100255344 ou US 2002/0068201 A1 (ci-après D1), comporte les étapes :

a) fournir le substrat, le substrat étant transparent dans ledit domaine spectral,
b) former au moins une couche de séparation sur le substrat, le domaine spectral des irradiations électromagnétiques étant adapté de sorte que la ou les couches de séparation sont absorbantes dans ledit domaine spectral,
c) former la structure à séparer sur la ou les couches de séparation,
d) exposer la ou les couches de séparation aux irradiations électromagnétiques via le substrat pendant une durée d'exposition à une densité de puissance donnée de sorte que la ou les couches de séparation se décomposent sous l'effet de la chaleur issue de l'absorption desdites irradiations électromagnétiques.

La structure à séparer peut être transférée sur un substrat final après séparation. La structure à séparer peut comporter au moins une couche active. Par « active », on entend une couche sur laquelle ou dans laquelle seront fabriqués des composants destinés à des applications notamment dans le domaine de la microélectronique.

Dans D1, la structure à séparer est une couche réalisée dans un matériau du type (Al, Ga, In)N. Le substrat utilisé dans D1 est un substrat dit modèle (*template* en langue anglaise) sacrificiel. D1 envisage une ou plusieurs couches de séparation (voir [0073]).

Un tel procédé de séparation de l'état de la technique n'est pas entièrement satisfaisant dans la mesure où la chaleur issue de l'absorption des irradiations électromagnétiques par la ou les couches de séparation est susceptible de dégrader fortement le substrat et/ou la structure à séparer, et ce d'autant plus lorsque le substrat et la structure à séparer présentent des coefficients de dilation thermique sensiblement différents. C'est pourquoi le substrat utilisé dans D1 est un substrat sacrificiel qui ne peut être recyclé. Par ailleurs, la dégradation de la structure à séparer est susceptible d'engendrer la dégradation de la ou des couches actives.

La présente invention vise à remédier en tout ou partie aux inconvénients précités et concerne un procédé de séparation d'une structure d'un substrat par irradiations électromagnétiques appartenant à un domaine spectral, le procédé de séparation étant défini par les termes de la revendication 1.

Ainsi, un tel procédé de séparation selon l'invention permet de protéger la structure à séparer de la chaleur issue de l'absorption des irradiations électromagnétiques par la ou les couches de séparation par l'intermédiaire de la couche de barrière thermique. La couche de barrière thermique est transparente dans le domaine spectral des irradiations électromagnétiques afin de ne pas générer de la chaleur à proximité de la structure à séparer, ce qui serait le cas si la couche de barrière thermique était absorbante dans le domaine spectral des irradiations électromagnétiques. La couche de barrière thermique présente une épaisseur adaptée à la durée d'exposition afin de maintenir la température de la structure à séparer inférieure à un seuil. Si l'épaisseur de la couche de barrière thermique est un paramètre fixé, alors la durée d'exposition est adaptée à ladite épaisseur afin de maintenir la température de la structure à séparer inférieure à un seuil.

Dans l'invention, les irradiations électromagnétiques sont des impulsions électromagnétiques, et la durée d'exposition et l'épaisseur de la couche de barrière thermique, notée $E_1$, vérifient la relation suivante :

$$E_1 \geq \sqrt{2D_1\tau} \; ;$$ où $D_1$ est le coefficient de diffusion thermique de la couche de barrière thermique, $\tau$ est la durée d'une impulsion électromagnétique.

Ainsi, l'épaisseur de la couche de barrière thermique est supérieure à la longueur de diffusion thermique dans la couche de barrière thermique. Il est préférable de choisir un matériau pour la couche de barrière thermique et une durée d'une impulsion électromagnétique tels que la longueur de diffusion thermique est faible relativement à l'épaisseur de la couche de barrière thermique afin de confiner au mieux la chaleur issue de l'absorption des irradiations électromagnétiques par la ou les couches de séparation. Cela revient à minimiser $D_1\tau$. Un autre avantage d'une faible diffusion thermique est qu'il est possible d'envisager une faible épaisseur pour la couche de barrière thermique. Cela conduit à un gain de temps d'exécution du procédé par exemple lorsque la couche de barrière thermique est formée par épitaxie.

Dans un mode de mise en oeuvre, le procédé de séparation comporte une étape a1) former une couche de barrière thermique additionnelle sur le substrat, le domaine spectral des irradiations électromagnétiques étant adapté de sorte que la couche de barrière thermique additionnelle est transparente dans ledit domaine spectral, la durée d'exposition et l'épaisseur de la couche de barrière thermique additionnelle étant adaptées de sorte que la température du substrat demeure inférieure à un seuil pendant la durée d'exposition au-delà duquel des défauts sont susceptibles d'apparaitre dans ledit substrat, et l'étape b) est exécutée de sorte que la ou les couches de séparation sont formées sur la couche de barrière thermique additionnelle.

Ainsi, un tel procédé de séparation selon l'invention permet de protéger le substrat de la chaleur issue de l'absorption des irradiations électromagnétiques par la ou les couches de séparation par l'intermédiaire de la couche de barrière thermique additionnelle. Il est donc possible de recycler le substrat.

La couche de barrière thermique additionnelle est transparente dans le domaine spectral des irradiations électromagnétiques afin :

- d'autoriser l'exposition de la ou des couches de séparation aux irradiations électromagnétiques, et
- de ne pas générer de la chaleur à proximité du substrat.

La couche de barrière thermique additionnelle présente une épaisseur adaptée à la durée d'exposition afin de maintenir la température du substrat inférieure à un seuil. Si l'épaisseur de la couche de barrière thermique additionnelle est un paramètre fixé, alors la durée d'exposition est adaptée à ladite épaisseur afin de maintenir la température du substrat inférieure à un seuil.

Selon une forme d'exécution, les irradiations électromagnétiques sont des impulsions électromagnétiques, et la durée d'exposition et l'épaisseur de la couche de barrière thermique additionnelle, notée $E_2$, vérifient

$$E_2 \geq \sqrt{2D_2\tau} \quad ;$$

la relation suivante : où $D_2$ est le coefficient de diffusion thermique de la couche de barrière thermique additionnelle, $\tau$ est la durée d'une impulsion électromagnétique.

Ainsi, l'épaisseur de la couche de barrière thermique additionnelle est supérieure à la longueur de diffusion thermique dans la couche de barrière thermique additionnelle. Il est préférable de choisir un matériau pour la couche de barrière thermique additionnelle et une durée d'une impulsion électromagnétique tels que la longueur de diffusion thermique est faible relativement à l'épaisseur de la couche de barrière thermique additionnelle afin de confiner au mieux la chaleur issue de l'absorption des irradiations électromagnétiques par la ou les couches de séparation. Cela revient à minimiser $D_2\tau$. Un autre avantage d'une faible diffusion thermique est qu'il est possible d'envisager une faible épaisseur pour la couche de barrière thermique additionnelle. Cela conduit à un gain de temps d'exécution du procédé par exemple lorsque la couche de barrière thermique additionnelle est formée par épitaxie.

Dans un mode de mise en oeuvre, la couche de barrière thermique et la couche de barrière thermique additionnelle présentent chacune un coefficient de diffusion thermique, et la durée d'exposition des irradiations électromagnétiques et lesdits coefficients de diffusion thermique sont adaptés de sorte que la chaleur issue de l'absorption des irradiations électromagnétiques par la ou les couches de séparation est confinée entre la couche de barrière thermique et la couche de barrière thermique additionnelle.

Ainsi, un tel confinement permet à la fois d'améliorer la décomposition de la ou des couches de séparation et la protection de la structure à séparer et du substrat.

Dans un mode de mise en oeuvre, la couche de barrière thermique additionnelle est réalisée dans un matériau présentant un paramètre de maille compris entre le paramètre de maille du substrat et le paramètre de maille de la ou les couches de séparation, les étapes a1) et b) étant de préférence exécutées par épitaxie.

Ainsi, la couche de barrière thermique additionnelle assure une fonction supplémentaire de couche tampon pour l'adaptation des paramètres de maille, et ce afin d'obtenir une épitaxie avec un minimum de défauts.

Dans un mode de mise en oeuvre, la couche de barrière thermique est réalisée dans un matériau présentant un paramètre de maille compris entre le paramètre de maille de la structure à séparer et le paramètre de maille de la ou les couches de séparation, les étapes c) et d) étant de préférence exécutées par épitaxie.

Ainsi, la couche de barrière thermique assure une fonction supplémentaire de couche tampon pour l'adaptation des paramètres de maille, et ce afin d'obtenir une épitaxie avec un minimum de défauts.

Selon une forme d'exécution, le substrat comporte du GaN, la ou les couches de séparation comportent de l'$In_{(x)}Ga_{(1-x)}N$, $0,10 \leq x \leq 0.20$, de préférence $0,12 \leq x \leq 0.15$, la couche de barrière thermique et/ou la couche de barrière thermique additionnelle comporte de l'AlGaN, et le domaine spectral des irradiations électromagnétiques est compris entre 400 et 450 nm.

Selon une autre forme d'exécution, le substrat comporte de l'InP, la ou les couches de séparation comportent de l'$In_{(x)}Ga_{(1-x)}As$, de préférence x<0,95, encore préférentiellement x=0,53, la couche de barrière thermique et/ou la couche de barrière thermique additionnelle comporte de l'InAlAs, de préférence de l'$In_{0,52}Al_{0,48}As$, et le domaine spectral des irradiations électromagnétiques est compris entre 1000 et 3500 nm, de préférence entre 1100 et 1500 nm.

Selon une caractéristique, l'étape d) est exécutée par l'intermédiaire d'au moins un laser émettant les irradiations électromagnétiques associé à un oscillateur paramétrique optique.

Ainsi, un tel laser associé à un oscillateur paramétrique permet d'obtenir des irradiations électromagnétiques couvrant un important domaine spectral, par exemple de 400 nm à 2200 nm, ce qui permet un large choix de matériaux pour les couches de séparation.

La présente invention se rapporte également à un empilement de séparation d'une structure d'un substrat tel que défini par les termes de la revendication 10.

Ainsi, un tel empilement de séparation selon l'invention permet de protéger la structure à séparer de la chaleur issue de l'absorption des irradiations électromagnétiques par la ou les couches de séparation par l'intermédiaire de la couche de barrière thermique. La couche de barrière thermique est transparente dans le domaine spectral des irradiations électromagnétiques afin de ne pas générer de la chaleur à proximité de la structure à séparer, ce qui serait le cas si la couche de barrière thermique était absorbante dans le domaine spectral des irradiations électromagnétiques. La couche de barrière thermique présente une épaisseur adaptée à la durée d'exposition afin de maintenir la température de la structure à séparer inférieure à un seuil.

Ainsi, l'épaisseur de la couche de barrière thermique est supérieure à la longueur de diffusion thermique dans la couche de barrière thermique. Il est préférable de choisir un matériau pour la couche de barrière thermique tel que la longueur de diffusion thermique est faible relativement à l'épaisseur de la couche de barrière thermique afin de confiner au mieux la chaleur issue de l'absorption des irradiations électromagnétiques par la ou les couches de séparation. Cela revient à minimiser $D_1 \tau$. Un autre avantage d'une faible diffusion thermique est qu'il est possible d'envisager une faible épaisseur pour la couche de barrière thermique. Cela conduit à un gain de temps d'exécution du procédé par exemple lorsque la couche de barrière thermique est formée par épitaxie.

Dans un mode de réalisation, l'empilement de séparation comporte une couche de barrière thermique additionnelle agencée entre la ou les couches de séparation et le substrat, la couche de barrière additionnelle étant transparente dans le domaine spectral, la couche de barrière thermique additionnelle présentant une épaisseur adaptée à la durée d'exposition de sorte que la température du substrat demeure inférieure à un seuil pendant la durée d'exposition au-delà duquel des défauts sont susceptibles d'apparaitre dans le substrat.

Ainsi, un tel empilement de séparation selon l'invention permet de protéger le substrat de la chaleur issue de l'absorption des irradiations électromagnétiques par la ou les couches de séparation par l'intermédiaire de la couche de barrière thermique additionnelle. Il est donc possible de recycler le substrat.
La couche de barrière thermique additionnelle est transparente dans le domaine spectral des irradiations électromagnétiques afin :

- d'autoriser l'exposition de la ou des couches de séparation aux irradiations électromagnétiques, et
- de ne pas générer de la chaleur à proximité du substrat.

La couche de barrière thermique additionnelle présente une épaisseur adaptée à la durée d'exposition afin de maintenir la température du substrat inférieure à un seuil.

Dans un mode de réalisation, la couche de barrière thermique et la couche de barrière thermique additionnelle présentent chacune un coefficient de diffusion thermique, et lesdits coefficients de diffusion thermique sont adaptés relativement à la durée d'exposition des irradiations électromagnétiques de sorte que la chaleur issue de l'absorption des irradiations électromagnétiques par la ou les couches de séparation est confinée entre la couche de barrière thermique et la couche de barrière thermique additionnelle.

Ainsi, un tel confinement permet à la fois d'améliorer la décomposition de la ou des couches de séparation et la protection de la structure à séparer et du substrat.

Dans un mode de réalisation, la couche de barrière thermique additionnelle est réalisée dans un matériau présentant un paramètre de maille compris entre le paramètre de maille du substrat et le paramètre de maille de la ou les couches de séparation.

Ainsi, la couche de barrière thermique additionnelle assure une fonction supplémentaire de couche tampon pour l'adaptation des paramètres de maille.

Dans un mode de réalisation, la couche de barrière thermique est réalisée dans un matériau présentant un paramètre de maille compris entre le paramètre de maille de la structure à séparer et le paramètre de maille de la ou les couches de séparation.

Ainsi, la couche de barrière thermique assure une fonction supplémentaire de couche tampon pour l'adaptation des paramètres de maille.

Selon une forme d'exécution, le substrat comporte du GaN, la ou les couches de séparation comportent de l'$In_{(x)}Ga_{(1-x)}N$, $0,10 \leq x \leq 0.20$, de préférence $0,12 \leq x \leq 0.15$, la couche de barrière thermique et/ou la couche de barrière thermique additionnelle comporte de l'AlGaN, et le domaine spectral des irradiations électromagnétiques est compris entre 400 et 450 nm.

Selon une autre forme d'exécution, le substrat comporte de l'InP, la ou les couches de séparation comportent de l'$In_{(x)}Ga_{(1-x)}As$, de préférence x<0,95, encore préférentiellement x=0,53, la couche de barrière thermique et/ou la couche de barrière thermique additionnelle comporte de l'InAlAs, de préférence de l'$In_{0,52}Al_{1,48}As$, et le domaine spectral des irradiations électromagnétiques est compris entre 1000 et 3500 nm, de préférence entre 1100 et 1500 nm.

La présente invention se rapporte également à un ensemble de séparation comportant :

- un empilement de séparation conforme à l'invention,
- un dispositif agencé pour exposer la ou les couches de séparation à des irradiations électromagnétiques via le substrat pendant une durée d'exposition à une densité de puissance donnée de sorte, que la ou les couches de séparation se décomposent sous l'effet de la chaleur issue de l'absorption desdites irradiations électromagnétiques, le dispositif comprenant de préférence un laser émettant lesdites irradiations électromagnétiques associé à un oscillateur paramétrique optique.

Ainsi, un tel laser associé à un oscillateur paramétrique permet d'obtenir des irradiations électromagnétiques couvrant un important domaine spectral, par exemple de 400 nm à 2200 nm, ce qui permet un large choix de matériaux pour les couches de séparation.

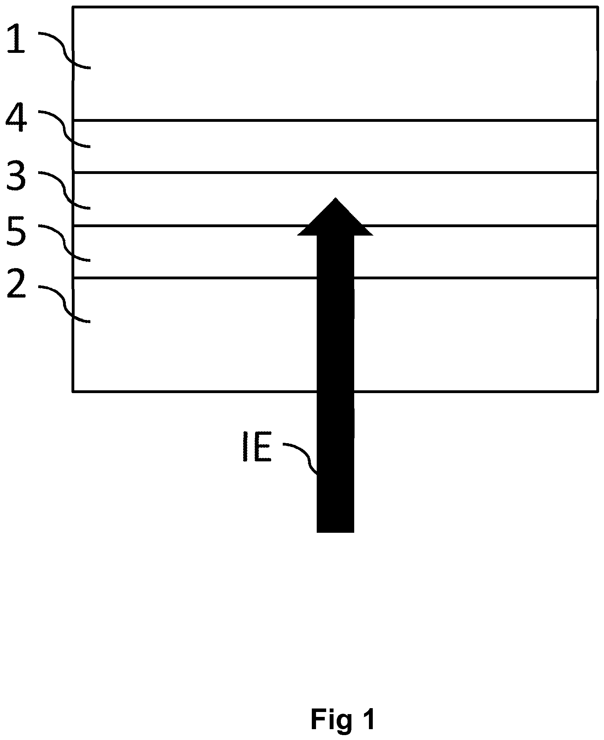

D'autres caractéristiques et avantages apparaîtront dans la description qui va suivre de deux modes de réalisation d'un empilement de séparation selon l'invention, donnés à titre d'exemples non limitatifs, en référence aux dessins annexés dans lesquels la figure 1 est une vue schématique d'un empilement de séparation conforme à l'invention.

Pour les différents modes de réalisation, les mêmes références seront utilisées pour des éléments identiques ou assurant la même fonction, par souci de simplification de la description.

L'empilement de séparation illustré à la figure 1 est un empilement de séparation d'une structure 1 d'un substrat 2 par irradiations électromagnétiques IE appartenant à un domaine spectral pendant une durée d'exposition à une densité de puissance donnée.

La structure 1 à séparer peut être transférée sur un substrat final après séparation. La structure 1 à séparer peut comporter au moins une couche active. Par « active », on entend une couche sur laquelle ou dans laquelle seront fabriqués des composants destinés à des applications notamment dans le domaine de la microélectronique.

L'empilement de séparation comporte :

- le substrat 2 transparent dans le domaine spectral,
- une couche de séparation 3 absorbante dans le domaine spectral, et susceptible de se décomposer sous l'effet de la chaleur issue de l'absorption desdites irradiations électromagnétiques IE,
- la structure 1 à séparer,
- une couche de barrière thermique 4 agencée entre la couche de séparation 3 et la structure 1,
- une couche de barrière thermique additionnelle 5 agencée entre la couche de séparation 3 et le substrat 1, la couche de barrière thermique 4 et la couche de barrière thermique additionnelle 5 étant transparentes dans le domaine spectral.

La couche de séparation 3 peut comporter une sous-couche absorbante dans le domaine spectral et une sous-couche adjacente susceptible de se décomposer sous l'effet de la chaleur issue de l'absorption des irradiations électromagnétiques IE par la sous-couche absorbante. La décomposition de la couche de séparation 3 peut être une décomposition thermique ou une relaxation des contraintes thermomécaniques.

La durée d'exposition et l'épaisseur de la couche de barrière thermique 4 sont adaptées de sorte que la température de la structure 1 à séparer demeure inférieure à un seuil pendant la durée d'exposition au-delà duquel des défauts sont susceptibles d'apparaitre dans ladite structure 1. De même, la durée d'exposition et l'épaisseur de la couche de barrière thermique additionnelle 5 sont adaptées de sorte que la température du substrat 2 demeure inférieure à un seuil pendant la durée d'exposition au-delà duquel des défauts sont susceptibles d'apparaitre dans ledit substrat 2. A cet effet, lorsque les irradiations électromagnétiques IE sont des impulsions électromagnétiques, la durée d'exposition et l'épaisseur de la couche de barrière thermique 4, notée $E_1$, vérifient la relation suivante : $E_1 \geq \sqrt{2D_1\tau}$ ; où $D_1$ est le coefficient de diffusion thermique de la couche de barrière thermique 4, $\tau$ est la durée d'une impulsion électromagnétique. De même, la durée d'exposition et l'épaisseur de la couche de barrière thermique additionnelle 5, notée $E_2$, vérifient la relation suivante : $E_2 \geq \sqrt{2D_2\tau}$ ; où $D_2$ est le coefficient de diffusion thermique de la couche de barrière thermique additionnelle 5, $\tau$ est la durée d'une impulsion électromagnétique.

La couche de barrière thermique 4 et la couche de barrière thermique additionnelle 5 présentent chacune un coefficient de diffusion thermique $D_1$, $D_2$. La durée d'exposition des irradiations électromagnétiques IE et lesdits coefficients de diffusion thermique D1, D2 sont adaptés de sorte que la chaleur issue de l'absorption des irradiations électromagnétiques IE par la couches de séparation 3 est confinée entre la couche de barrière thermique 4 et la couche de barrière thermique additionnelle 5. En d'autres termes, la longueur de diffusion thermique dans la barrière thermique 4 est faible relativement à l'épaisseur de la couche de barrière thermique 4. De la même façon, la longueur de diffusion thermique dans la couche de barrière additionnelle 5 est faible relativement à l'épaisseur de la couche de barrière additionnelle 5.

La couche de barrière thermique 4 est réalisée dans un matériau présentant un paramètre de maille compris entre le paramètre de maille de la structure 1 à séparer et le paramètre de maille de la couche de séparation 3. La couche de barrière thermique additionnelle 5 est réalisée dans un matériau présentant un paramètre de maille compris entre le paramètre de maille du substrat 2 et le paramètre de maille de la couche de séparation 3.

Les irradiations électromagnétiques IE peuvent être émises par un laser associé à un oscillateur paramétrique optique.

Dans un premier mode de réalisation, le substrat 2 comporte du GaN. La couche de séparation 3 comporte de l'$In_{(x)}Ga_{(1-x)}N$, $0,10 \leq x \leq 0.20$, de préférence $0,12 \leq x \leq 0.15$. La couche de barrière thermique 4 et la couche de barrière thermique additionnelle 5 comportent chacune de l'AlGaN. De telles couches de barrière thermique 4, 5 forment des couches tampon pour l'adaptation des paramètres de maille.

Le domaine spectral des irradiations électromagnétiques IE est compris entre 400 et 450 nm.

Les irradiations électromagnétiques IE sont des impulsions électromagnétiques pouvant être émises par un laser Nd : YAG émettant à 355 nm de type commutation-Q (*Q-switch* en langue anglaise), dont la durée des impulsions est 7 ns et la fréquence des impulsions est 20 Hz. Le laser est associé à un oscillateur paramétrique optique couvrant un domaine spectral de 400 à 2200 nm. La densité de puissance du laser peut être comprise entre 1 J.cm$^{-2}$ et 5 J.cm$^{-2}$ dans le domaine spectral compris entre 400 et 450 nm.

Dans un second mode de réalisation, l'empilement de séparation diffère de celui du premier mode de réalisation en ce que le substrat 2 comporte de l'InP, en ce que la couche de séparation 3 comporte de l'In$_{(x)}$Ga$_{(1-x)}$As, de préférence x<0,95, encore préférentiellement x=0,53, en ce que la couche de barrière thermique 4 et la couche de barrière thermique additionnelle 5 comportent de l'InAlAs, de préférence de l'In$_{0,52}$Al$_{0,48}$As, et en ce que le domaine spectral des irradiations électromagnétiques IE est compris entre 1100 et 1500 nm. La densité de puissance du laser peut être comprise entre 0,05 J.cm$^{-2}$ et 0,3 J.cm$^{-2}$ dans le domaine spectral compris entre 1100 et 1500 nm.

Bien entendu, les modes de réalisation de l'invention décrits ci-dessus ne présentent aucun caractère limitatif. Des détails et améliorations peuvent y être apportés dans d'autres variantes d'exécution sans pour autant sortir du cadre de l'invention.

## Revendications

1. Procédé de séparation d'une structure (1) d'un substrat (2) par irradiations électromagnétiques (IE) appartenant à un domaine spectral, le procédé de séparation comportant les étapes :

   a) fournir le substrat (2), le substrat (2) étant transparent dans ledit domaine spectral,
   b) former au moins une couche de séparation (3) sur le substrat (2), le domaine spectral des irradiations électromagnétiques (IE) étant adapté de sorte que la ou les couches de séparation (3) sont absorbantes dans ledit domaine spectral,
   b1) former une couche de barrière thermique (4) sur la ou les couches de séparation (3), le domaine spectral des irradiations électromagnétiques (IE) étant adapté de sorte que la couche de barrière thermique (4) est transparente dans ledit domaine spectral ;
   c) former la structure (1) à séparer sur la couche de barrière thermique (4),
   d) exposer la ou les couches de séparation (3) aux irradiations électromagnétiques (IE) via le substrat (2) pendant une durée d'exposition à une densité de puissance donnée de sorte que la ou les couches de séparation (3) se décomposent sous l'effet de la chaleur issue de l'absorption desdites irradiations électromagnétiques (IE), le procédé de séparation étant caractérisé en ce que les irradiations électromagnétiques (IE) sont des impulsions électromagnétiques ; et la durée d'exposition et l'épaisseur de la couche de barrière thermique (4), notée E1, :

   - sont adaptées de sorte que la température de la structure (1) à séparer demeure inférieure à un seuil pendant la durée d'exposition au-delà duquel des défauts sont susceptibles d'apparaître dans ladite structure (1),
   - vérifient la relation suivante :

   $$E_1 \geq \sqrt{2D_1\tau} \; ;$$

   où D$_1$ est le coefficient de diffusion thermique de la couche de barrière thermique (4), $\tau$ est la durée d'une impulsion électromagnétique.

2. Procédé de séparation selon la revendication 1 **caractérisé en ce qu'**il comporte une étape a1) former une couche de barrière thermique additionnelle (5) sur le substrat (2), le domaine spectral des irradiations électromagnétiques (IE) étant adapté de sorte que la couche de barrière thermique additionnelle (5) est transparente dans ledit domaine spectral, la durée d'exposition et l'épaisseur de la couche de barrière thermique additionnelle (5) étant adaptées de sorte que la température du substrat (2) demeure inférieure à un seuil pendant la durée d'exposition au-delà duquel des défauts sont susceptibles d'apparaitre dans ledit substrat (2), et **en ce que** l'étape b) est exécutée de sorte que la ou les couches de séparation (3) sont formées sur la couche de barrière thermique additionnelle (5).

3. Procédé de séparation selon la revendication 2, **caractérisé en ce que** la durée d'exposition et l'épaisseur de la couche de barrière thermique additionnelle (5), notée E$_2$, vérifient la relation suivante :

   $$E_2 \geq \sqrt{2D_2\tau} \; ;$$

   où D$_2$ est le coefficient de diffusion thermique de la couche de barrière thermique additionnelle (5).

4. Procédé de séparation selon la revendication 2 ou 3, **caractérisé en ce que** la couche de barrière thermique (4) et la couche de barrière thermique additionnelle (5) présentent chacune un coefficient de diffusion thermique, et **en ce que** la durée d'exposition des irradiations électromagnétiques et lesdits coefficients de diffusion thermique sont adaptés de sorte que la chaleur issue de l'absorption des irradiations électromagnétiques (IE) par la ou les couches de séparation (3) est confinée entre la couche de barrière thermique (4) et la couche de barrière thermique additionnelle (5).

5. Procédé de séparation selon l'une des revendications 2 à 4, **caractérisé en ce que** la couche de barrière thermique additionnelle (5) est réalisée dans un matériau présentant un paramètre de maille compris entre le paramètre de maille du substrat (2) et le paramètre de maille de la ou les couches de séparation (3), les étapes a1) et b) étant de préférence exécutées par épitaxie.

6. Procédé de séparation selon l'une des revendications 1 à 5, **caractérisé en ce que** la couche de barrière thermique (4) est réalisée dans un matériau présentant un paramètre de maille compris entre le paramètre de maille de la structure (1) à séparer et le paramètre de maille de la ou les couches de séparation (3), les étapes c) et d) étant de préférence exécutées par épitaxie.

7. Procédé de séparation selon l'une des revendications 1 à 6, **caractérisé en ce que** le substrat (2) comporte du GaN, **en ce que** la ou les couches de séparation (3) comportent de l'$In_{(x)}Ga_{(1-x)}N$, $0,10 \leq x \leq 0.20$, de préférence $0,12 \leq x \leq 0.15$, **en ce que** la couche de barrière thermique (4) comporte de l'AlGaN, et **en ce que** le domaine spectral des irradiations électromagnétiques (IE) est compris entre 400 et 450 nm.

8. Procédé de séparation selon l'une des revendications 1 à 6, **caractérisé en ce que** le substrat (2) comporte de l'InP, **en ce que** la ou les couches de séparation (3) comportent de l'$In_{(x)}Ga_{(1-x)}As$, de préférence x<0,95, encore préférentiellement x=0,53, **en ce que** la couche de barrière thermique (4) comporte de l'InAlAs, de préférence de l'$In_{0,52}Al_{0,48}As$, et **en ce que** le domaine spectral des irradiations électromagnétiques (IE) est compris entre 1000 et 3500 nm, de préférence entre 1100 et 1500 nm.

9. Procédé de séparation selon l'une des revendications 1 à 8, **caractérisé en ce que** l'étape d) est exécutée par l'intermédiaire d'au moins un laser émettant les irradiations électromagnétiques (IE) associé à un oscillateur paramétrique optique.

10. Empilement de séparation d'une structure (1) d'un substrat (2) par des impulsions électromagnétiques (IE) appartenant à un domaine spectral pendant une durée d'exposition à une densité de puissance donnée, l'empilement de séparation comportant :

> - le substrat (2), le substrat (2) étant transparent dans ledit domaine spectral,
> - au moins une couche de séparation (3) formée sur le substrat, la ou les couches de séparation (3) étant absorbantes dans le domaine spectral, la ou les couches de séparation (3) étant susceptibles de se décomposer sous l'effet de la chaleur issue de l'absorption desdites impulsions électromagnétiques (IE),
- la structure (1) à séparer formée sur la ou les couches de séparation (3),
- une couche de barrière thermique (4) agencée entre la ou les couches de séparation (3) et la structure (1) à séparer, la couche de barrière thermique (4) étant transparente dans le domaine spectral,

l'empilement de séparation étant **<u>caractérisé en ce que</u>** la couche de barrière thermique (4) présente une épaisseur, notée $E_1$ :

> - adaptée à la durée d'exposition de sorte que la température de la structure (1) à séparer demeure inférieure à un seuil pendant la durée d'exposition au-delà duquel des défauts sont susceptibles d'apparaitre dans ladite structure (1) ;

- et vérifie la relation $E_1 \geq \sqrt{2D_1\tau}$ ; où $D_1$ est le coefficient de diffusion thermique de la couche de barrière thermique (4), $\tau$ est la durée d'une impulsion électromagnétique.

11. Empilement de séparation selon la revendication 10, **caractérisé en ce qu'**il comporte une couche de barrière thermique additionnelle (5) agencée entre la ou les couches de séparation (3) et le substrat (2), la couche de barrière additionnelle (5) étant transparente dans le domaine spectral, la couche de barrière thermique additionnelle (5) présentant une épaisseur adaptée à la durée d'exposition de sorte que la température du substrat (2) demeure inférieure à un seuil pendant la durée d'exposition au-delà duquel des défauts sont susceptibles d'apparaitre dans le substrat (2).

12. Empilement de séparation selon la revendication 11, l'épaisseur de la couche de barrière thermique additionnelle (5), notée $E_2$, vérifie la relation suivante :

$E_2 \geq \sqrt{2D_2\tau}$ ; où $D_2$ est le coefficient de diffusion thermique de la couche de barrière thermique additionnelle (5).

13. Empilement de séparation selon la revendication 11 ou 12, **caractérisé en ce que** la couche de barrière thermique (4) et la couche de barrière thermique additionnelle (5) présentent chacune un coefficient de diffusion thermique, et **en ce que** lesdits coefficients de diffusion thermique sont adaptés relativement à la durée d'exposition des impulsions électromagnétiques (IE) de sorte que la chaleur issue de l'absorption des impulsions électromagnétiques (IE) par la ou les couches de séparation (3) est confinée entre la couche de barrière thermique (4) et la couche de barrière thermique additionnelle (5).

14. Empilement de séparation selon l'une des revendications 11 à 13, **caractérisé en ce que** la couche de barrière thermique additionnelle (5) est réalisée dans un matériau présentant un paramètre de maille compris entre le paramètre de maille du substrat (2) et le paramètre de maille de la ou les couches de séparation (3).

15. Empilement de séparation selon l'une des revendications 10 à 14, **caractérisé en ce que** la couche de barrière thermique (4) est réalisée dans un matériau présentant un paramètre de maille compris entre le paramètre de maille de la structure (1) à séparer et le paramètre de maille de la ou les couches de séparation (3).

16. Empilement de séparation selon l'une des revendications 10 à 15, **caractérisé en ce que** le substrat (2) comporte du GaN, **en ce que** la ou les couches de séparation (3) comportent de l'In$_{(x)}$Ga$_{(1-x)}$N, $0,10 \leq x \leq 0.20$, de préférence $0,12 \leq x \leq 0.15$, **en ce que** la couche de barrière thermique (4) comporte de l'AlGaN, et **en ce que** le domaine spectral des impulsions électromagnétiques (IE) est compris entre 400 et 450 nm.

17. Empilement de séparation selon l'une des revendications 10 à 15, **caractérisé en ce que** le substrat (2) comporte de l'InP, **en ce que** la ou les couches de séparation (3) comportent de l'In$_{(x)}$Ga$_{(1-x)}$As, de préférence x<0,95, encore préférentiellement x=0,53, **en ce que** la couche de barrière thermique (4) comporte de l'InAlAs, de préférence de l'In$_{0,52}$Al$_{0,48}$As, et **en ce que** le domaine spectral des impulsions électromagnétiques (IE) est compris entre 1000 et 3500 nm, de préférence entre 1100 et 1500 nm.

18. Ensemble de séparation comportant :

- un empilement de séparation selon l'une des revendications 10 à 17,
- un dispositif agencé pour exposer la ou les couches de séparation (3) à des impulsions électromagnétiques (IE) via le substrat (2) pendant une durée d'exposition à une densité de puissance donnée de sorte que la ou les couches de séparation (3) se décomposent sous l'effet de la chaleur issue de l'absorption desdites impulsions électromagnétiques (IE), le dispositif comprenant de préférence un laser émettant lesdites impulsions électromagnétiques (IE) associé à un oscillateur paramétrique optique.

## Patentansprüche

1. Verfahren zum Trennen einer Struktur (1) eines Substrats (2) durch elektromagnetische Strahlungen (IE), die zu einem Spektralbereich gehören, wobei das Trennverfahren folgende Schritte umfasst:

a) die Bereitstellung des Substrats (2), wobei das Substrat (2) in besagtem Spektralbereich transparent ist,
b) das Formen mindestens einer Trennschicht (3) auf dem Substrat (2), wobei der Spektralbereich der elektromagnetischen Strahlungen (IE) so angepasst ist, dass die Trennschicht bzw. die Trennschichten (3) in besagtem Spektralbereich absorbierend sind,
b1) die Bildung einer thermischen Sperrschicht (4) auf der oder den Trennschichten (3), wobei der Spektralbereich der elektromagnetischen Strahlungen (IE) so angepasst ist, dass die thermische Sperrschicht (4) in besagtem Spektralbereich transparent ist;
c) das Bilden der zu trennenden Struktur (1) auf der thermischen Sperrschicht (4),
d) das Exponieren der Trennschicht bzw. Trennschichten (3) gegenüber der elektromagnetischen Strahlungen (IE) über das Substrat (2) für eine bestimmte Expositionsdauer mit einer gegebenen Leistungsdichte, sodass sich die Trennschicht bzw. die Trennschichten (3) unter Einwirkung der von der Absorption besagter elektromagnetischer Strahlen (IE) stammenden Wärme zersetzen, wobei das Trennverfahren **dadurch gekennzeichnet ist, dass** die elektromagnetischen Strahlungen (IE) elektromagnetische Impulse sind, und die Expositionsdauer und die Dicke der thermischen Sperrschicht (4), notiert E1,:

- so angepasst sind, dass die Temperatur der zu trennenden Struktur (1) während der Expositionsdauer unter einem Grenzwert bleibt, ab dem in besagter Struktur (1) Fehler auftreten können,
- die folgende Beziehung prüfen:

$$E_1 \geq \sqrt{2D_1\tau}$$

; wo D1 die Wärmeleitzahl der thermischen Sperrschicht (4) ist und $\tau$ die Dauer eines elektromagnetischen Impulses.

2. Trennverfahren nach Anspruch 1, **dadurch gekennzeichnet, dass** es einen Schritt a1) umfasst, in dem eine zusätzliche thermische Sperrschicht (5) auf dem Substrat (2) gebildet wird, wobei der Spektralbereich der elektromagnetischen Strahlungen (IE) so angepasst ist, dass die zusätzliche thermische Sperrschicht (5) in besagtem Spektralbereich transparent ist, wobei die Expositionsdauer und die Dicke der zusätzlichen thermischen Sperrschicht (5) so angepasst ist, dass die Temperatur des Substrats (2) während der Expositionsdauer unter einem Grenzwert bleibt, ab dem in besagtem Substrat (2) Fehler auftreten können, und dadurch, dass Schritt b) so ausgeführt wird, dass die Trennschicht bzw. die Trennschichten (3) auf der zusätzlichen thermischen Wärmeschicht (5) gebildet werden.

3. Trennverfahren nach Anspruch 2, **dadurch gekennzeichnet, dass** die Expositionsdauer und die Dicke der zusätzlichen thermischen Sperrschicht (5), notiert E2, die folgende Beziehung prüfen:

$$E_2 \geq \sqrt{2D_2\tau} \;;$$

wo $D_2$ die Wärmeleitzahl der zusätzlichen thermischen Sperrschicht (5) ist.

4. Trennverfahren nach Anspruch 2 oder 3, **dadurch gekennzeichnet, dass** die thermische Sperrschicht (4) und die zusätzliche thermische Sperrschicht (5) jeweils eine Wärmeleitzahl aufweisen, und dadurch, dass die Expositionsdauer der elektromagnetischen Strahlungen und besagte Wärmeleitzahlen so angepasst sind, dass die Wärme, die von der Absorption der elektromagnetischen Strahlungen (IE) durch die Trennschicht bzw. die Trennschichten (3) stammt, zwischen der thermischen Sperrschicht (4) und der zusätzlichen thermischen Sperrschicht (5) eingeschlossen wird.

5. Trennverfahren nach einem der Ansprüche 2 bis 4, **dadurch gekennzeichnet, dass** die zusätzliche thermische Sperrschicht (5) aus einem Material hergestellt wird, welches einen Gitterparameter aufweist, der zwischen dem Gitterparameter des Substrats (2) und dem Gitterparameter der Trennschicht bzw. der Trennschichten (3) liegt, wobei die Schritte a1) und b) vorzugsweise durch Epitaxie ausgeführt werden.

6. Trennverfahren nach einem der Ansprüche 1 bis 5, **dadurch gekennzeichnet, dass** die thermische Sperrschicht (4) aus einem Material hergestellt wird, welches einen Gitterparameter aufweist, der zwischen dem Gitterparameter der zu trennenden Struktur (1) und dem Gitterparameter der Trennschicht bzw. Trennschichten (3) liegt, wobei die Schritte c) und d) vorzugsweise durch Epitaxie ausgeführt werden.

7. Trennverfahren nach einem der Ansprüche 1 bis 6, **dadurch gekennzeichnet, dass** das Substrat (2) GaN umfasst, und dadurch, dass die Trennschicht bzw. die Trennschichten (3) $In_{(X)}Ga_{(1-X)}N$, $0,10 \leq x \leq 0.20$, vorzugsweise $0,12 \leq x \leq 0.15$, enthalten, und dadurch, dass die thermische Sperrschicht (4) Al-GaN umfasst, und dadurch dass der Spektralbereich der elektromagnetischen Strahlungen (IE) zwischen 400 und 450 nm liegt.

8. Trennverfahren nach einem der Ansprüche 1 bis 6, **dadurch gekennzeichnet, dass** das Substrat (2) InP umfasst, und dadurch, dass die Trennschicht bzw. die Trennschichten (3) $In_{(X)}GA_{(1-X)}As$ umfassen, vorzugsweise X<0,95, besser noch X=0,53, und dadurch, dass die thermische Sperrschicht (4) InAlAs, vorzugsweise $In_{0,52}Al_{0,8}4As$, umfassen, und dadurch, dass der Spektralbereich der elektromagnetischen Strahlungen (IE) zwischen 1000 und 3500 nm, vorzugsweise aber zwischen 1100 1500 nm liegt.

9. Trennverfahren nach einem der Ansprüche 1 bis 8, **dadurch gekennzeichnet, dass** Schritt d) über mindestens einen Laser ausgeführt wird, welcher elektromagnetische Strahlen (IE) emittiert, in Verbindung mit einem optischen parametrischen Oszillator.

10. Stapel zum Trennen einer Struktur (1) eines Substrats (2) durch elektromagnetische Impulse (IE), welche zu einem Spektralbereich gehören, während einer Expositionsdauer mit einer gegebenen Leistungsdichte, wobei der Trennstapel folgendes umfasst:

   - das Substrat (2), wobei das Substrat (2) in besagtem Spektralbereich transparent ist,
   - mindestens eine Trennschicht (3), die auf dem Substrat gebildet wird, wobei die Trennschicht bzw. die Trennschichten (3) im Spektralbereich absorbierend sind, wobei sich die Trennschicht bzw. die Trennschichten (3) unter Einwirkung der von der Absorption besagter elektromagnetischer Impulse (IE) stammenden Wärme zersetzen können,
   - die zu trennende Struktur (1), welche auf der oder den Trennschichten (3) gebildet wird,
   - eine thermische Sperrschicht (4), die zwischen der oder den Trennschichten (3) und der zu trennenden Struktur (1) angeordnet ist, wobei die thermische Sperrschicht (4) im Spektralbereich transparent ist, wobei der Trennstapel **dadurch gekennzeichnet ist, dass** die thermische Trennschicht (4) eine Dicke, notiert E1, aufweist,:

   - die an die Dauer der Exposition angepasst ist, sodass die Temperatur der zu trennenden Struktur (1) während der Expositionsdauer unter einem Grenzwert bleibt, ab dem in besagter Struktur (1) Fehler auftreten können;

- und die Beziehung

$$E_1 \geq \sqrt{2D_1\tau}$$

prüft; wo $D_1$ die Wärmeleitzahl der thermischen Sperrschicht (4) und $\tau$ die Dauer eines elektromagnetischen Impulses ist.

11. Trennstapel nach Anspruch 10, **dadurch gekennzeichnet, dass** er eine zusätzliche thermische Sperrschicht (5) umfasst, die zwischen der oder den Trennschichten (3) und dem Substrat (2) angeordnet ist, wobei die zusätzliche Sperrschicht im Spektralbereich transparent ist, und die zusätzliche thermische Sperrschicht (5) einer Dicke aufweist, die an die Expositionsdauer angepasst ist, sodass die Temperatur des Substrats (2) während der Expositionsdauer unter einem Grenzwert bleibt, ab dem im Substrat (2) Fehler auftreten können.

12. Trennstapel nach Anspruch 11, wobei die Dicke der zusätzlichen thermischen Sperrschicht (5), notiert $E_2$, die folgende Beziehung

$$E_2 \geq \sqrt{2D_2\tau}$$

prüft, wo $D_2$ die Wärmeleitzahl der thermischen Sperrschicht (5) ist.

13. Trennstapel nach Anspruch 11 oder 12, **dadurch gekennzeichnet, dass** die thermische Sperrschicht (4) und die zusätzliche thermische Sperrschicht (5) jeweils eine Wärmeleitzahl aufweisen, und dadurch, dass besagte Wärmeleitzahlen relativ an die Expositionsdauer der elektromagnetischen Impulse (IE) angepasst sind, sodass die von der Absorption der elektromagnetischen Impulse (IE) durch die Trennschicht bzw. die Trennschichten (3) stammende Wärme zwischen der thermischen Sperrschicht (4) und der zusätzlichen thermischen Sperrschicht (5) eingeschlossen ist.

14. Trennstapel nach einem der Ansprüche 11 bis 13, **dadurch gekennzeichnet, dass** die zusätzliche thermische Sperrschicht (5) aus einem Material hergestellt wird, das einen Gitterparameter aufweist, der zwischen dem Gitterparameter des Substrats (2) und dem Gitterparameter der Trennschicht bzw. Trennschichten (3) liegt.

15. Trennstapel nach einem der Ansprüche 10 bis 14, **dadurch gekennzeichnet, dass** die thermische Sperrschicht (4) aus einem Material hergestellt wird, welches einen Gitterparameter aufweist, der zwischen dem Gitterparameter der zu trennenden Struktur (1) und dem Gitterparameter der Trennschicht bzw. Trennschichten (3) liegt.

16. Trennstapel nach einem der Ansprüche 10 bis 15, **dadurch gekennzeichnet, dass** das Substrat (2) GaN umfasst, und dadurch, dass die Trennschicht bzw. die Trennschichten (3) $In_{(X)}GA_{(1-X)}N$, $0,10 \leq x \leq 0.20$ vorzugsweise $0,12 \leq x \leq 0,15$ aufweisen, und dadurch, dass die thermische Sperrschicht (4) AlGaN umfasst, und dadurch, dass der Spektralbereich der elektromagnetischen Impulse (IE) zwischen 400 und 450 nm liegt.

17. Trennstapel einem der Ansprüche 10 bis 15, **dadurch gekennzeichnet, dass** das Substrat (2) InP umfasst, und dadurch, dass die Trennschicht bzw. die Trennschichten (3) $In_{(X)}GA_{(1-X)}As$ umfassen, vorzugsweise X<0,95, und ganz vorzugsweise X=0,53, und dadurch, dass die thermische Sperrschicht (4) InAlAs umfasst, vorzugsweise $In_{0,52}Al_{0,48}As$, und dadurch, dass der Spektralbereich der elektromagnetischen Impulse (IE) zwischen 1000 und 3500 nm, vorzugsweise aber zwischen 1100 und 1500 nm liegt.

18. Trennende Einheit, welche folgendes umfasst:

- einen Trennstapel nach einem der Ansprüche 10 bis 17,
- eine Vorrichtung, die so angeordnet ist, dass die Trennschicht bzw. die Trennschichten (3) während einer Expositionsdauer über das Substrat (2) mit einer gegebenen Leistungsdichte den elektromagnetischen Impulsen (IE) ausgesetzt ist, sodass sich die Trennschicht bzw. die Trennschichten (3) unter Einwirkung der von der Absorption besagter elektromagnetischer Impulse (IE) stammenden Wärme zersetzt, wobei die Vorrichtung vorzugsweise einen Laser enthält, der besagte elektromagnetische Impulse (IE) emittiert, in Verbindung mit einem optischen parametrischen Oszillator.

## Claims

1. A method for separating a structure (1) from a substrate (2) using electromagnetic radiations (IE) within a spectral range, with the separation method comprising the steps of:

a) providing the substrate (2), with the substrate (2) being transparent in said spectral range,
b) forming at least one separating layer (3) on the substrate (2), with the spectral range of the electromagnetic radiations (IE) being tailored so that the separating layer(s) (3) is/are absorbent in said spectral range,

b1) forming a thermal barrier layer (4) on the separating layer (s) (3), with the spectral range of the electromagnetic radiations (IE) being tailored so that the thermal barrier layer (4) is transparent in said spectral range,

c) forming the structure (1) to be separated on the thermal barrier layer (4),

d) exposing the separating layer(s) (3) to the electromagnetic radiations (IE) via the substrate (2) for an exposure time at a given power density so that the separating layer(s) (3) decompose(s) under the effect of the heat resulting from the absorption of said electromagnetic radiations (IE), with the separation method being **characterized in that** the electromagnetic radiations (IE) are electromagnetic pulses; and **in that** the exposure time and the thickness of the thermal barrier layer (4), noted E1:

- are tailored so that the temperature of the structure (1) to be separated remains below a threshold for the whole exposure time beyond which defects are likely to appear in said structure (1),
- satisfy the following relationship:

$$E_1 \geq \sqrt{2D_1\tau}$$

; where $D_1$ is the thermal diffusion coefficient of the thermal barrier layer (4), $\tau$ is the duration of an electromagnetic pulse.

2. A separation method according to claim 1, **characterized in that** it comprises a step a1) which consists in: forming an additional thermal barrier layer (5) on the substrate (2), with the spectral range of the electromagnetic radiations (IE) being tailored so that the additional thermal barrier layer (5) is transparent in said spectral range, with the exposure time and the thickness of the additional thermal barrier layer (5) being tailored so that the temperature of the substrate (2) remains below a threshold for the whole exposure time beyond which defects are likely to appear in said substrate (2), and **in that** step b) is carried out so that the separating layer (s) (3) is/are formed on the additional thermal barrier layer (5).

3. A separation method according to claim 2, **characterized in that** the exposure time and the thickness of the additional thermal barrier layer (5), noted $E_2$, satisfy the following relationship:

$$E_2 \geq \sqrt{2D_2\tau}$$

where $D_2$ is the thermal diffusion coefficient of the additional thermal barrier layer (5).

4. A separation method according to claim 2 or 3, **characterized in that** the thermal barrier layer (4) and the additional thermal barrier layer (5) each have a thermal diffusion coefficient, and **in that** the exposure time of the electromagnetic radiations and said thermal diffusion coefficients are tailored so that the heat resulting from the absorption of the electromagnetic radiations (IE) by the separating layer(s) (3) is confined between the thermal barrier layer (4) and the additional thermal barrier layer (5) .

5. A separation method according to one of claims 2 to 4, **characterized in that** the additional thermal barrier layer (5) is made of a material having a lattice parameter between the lattice parameter of the substrate (2) and the lattice parameter of the separating layer(s) (3), with steps a1) and b) being preferably carried out by epitaxy.

6. A separation method according to any one of claims 1 to 5, **characterized in that** the thermal barrier layer (4) is made of a material having a lattice parameter between the lattice parameter of the structure (1) to be separated and the lattice parameter of the separating layer(s) (3), with steps c) and d) being preferably carried out by epitaxy.

7. A separation method according to one of claims 1 to 6, **characterized in that** the substrate (2) comprises GaN, **in that** the separating layers (3) comprise (s) $In_{(x)}Ga_{(1-x)}N$, $0.10 \leq x \leq 0.20$, preferably $0.12 \leq x \leq 0.15$, **in that** the thermal barrier layer (4) comprises AlGaN, and **in that** the spectral range of the electromagnetic radiations (IE) ranges from 400 to 450nm.

8. A separation method according to one of claims 1 to 6, **characterized in that** the substrate (2) comprises InP, **in that** the separating layer(s) (3) comprise(s) $In_{(x)}Ga_{(1-x)}As$, preferably $x<0.95$, even more preferably $x=0.53$, **in that** the thermal barrier layer (4) comprises InAlAs, preferably $In_{0.52}Al_{0.48}As$, and **in that** the spectral range of the electromagnetic radiations (IE) ranges from 1,000 to 3,500nm, preferably from 1,100 to 1,500nm.

9. A separation method according to one of claims 1 to 8, **characterized in that** step d) is carried out using at least one laser emitting electromagnetic radiations (IE) associated with an optical parametric oscillator.

10. A stack for separating a structure (1) from a substrate (2) using electromagnetic radiations (IE) within a spectral range for an exposure time at a given power density, with the separation stack comprising:

- the substrate (2), with the substrate (2) being transparent in said spectral range,
- at least one separating layer (3) formed on the substrate, with the separating layer(s) (3) being absorbent in the spectral range, with the separating layer(s) (3) being likely to decompose under the effect of heat from the absorption of said electromagnetic pulses (EI),
- the structure (1) to be separated formed on the separating layer(s) (3),
- a thermal barrier layer (4) arranged between the separating layer(s) (3) and the structure (1) to be separated, with the thermal barrier layer (4) being transparent in the spectral range,

with the separation stack being **characterized in that** the thermal barrier layer (4) has a thickness, noted $E_1$:

- tailored to the exposure time so that the temperature of the structure (1) to be separated remains below a threshold for the whole exposure time beyond which defects are likely to appear in said structure (1);
- and satisfies the relationship

$$E_1 \geq \sqrt{2D_1\tau}$$ ;

where $D_1$ is the thermal diffusion coefficient of the thermal barrier layer (4), $\tau$ is the duration of an electromagnetic pulse.

11. A separation stack according to claim 10, **characterized in that** it comprises an additional thermal barrier layer (5) arranged between the separating layer(s) (3) and the substrate (2), with the additional thermal barrier layer (5) being transparent in the spectral range, with the additional thermal barrier layer (5) having a thickness tailored to the exposure time so that the temperature of the substrate (2) remains below a threshold for the whole exposure time beyond which defects are likely to appear in the substrate (2).

12. A separation stack according to claim 11, wherein the thickness of the additional thermal barrier layer (5), noted $E_2$, satisfies the following relationship:

$$E_2 \geq \sqrt{2D_2\tau}$$ ; where $D_2$ is the thermal diffusion coefficient of the additional thermal barrier layer (5).

13. A separation stack according to claim 11 or 12, **characterized in that** the thermal barrier layer (4) and the additional thermal barrier layer (5) each have a heat diffusion coefficient, and **in that** said heat diffusion coefficients are tailored relative to the exposure time of the electromagnetic pulses (IE), so that the heat resulting from the absorption of the electromagnetic pulses (IE) by the separating layers (3) is confined between the thermal barrier layer (4) and the additional thermal barrier layer (5) .

14. A separation stack according to one of claims 11 to 13, **characterized in that** the additional thermal barrier layer (5) is made of a material having a lattice parameter between the lattice parameter of the substrate (2) and the lattice parameter of the separating layer(s) (3).

15. A separation stack according to one of claims 10 to 14, **characterized in that** the thermal barrier layer (4) is made of a material having a lattice parameter between the lattice parameter of the structure (1) to be separated and the lattice parameter of the separating layer(s) (3).

16. A separation stack according to one of claims 10 to 15, **characterized in that** the substrate (2) comprises GaN, **in that** the separating layer(s) (3) comprise(s) $In_{(x)}Ga_{(1-x)}N$, $0.10 \leq x \leq 0.20$, preferably $0.12 \leq x \leq 0.15$, **in that** the thermal barrier layer (4) comprises AlGaN, and **in that** the spectral range of the electromagnetic radiations (IE) ranges from 400 to 450nm.

17. A separation stack according to one of claims 10 to 15, **characterized in that** the substrate (2) comprises $I\eta P$, **in that** the separating layer(s) (3) comprise(s) $In_{(x)}Ga_{(1-x)}As$, preferably x<0.95, even more preferably x=0.53, **in that** the thermal barrier layer (4) comprises InAlAs, preferably $In_{0.52}Al_{0.48}As$, and **in that** the spectral range of the electromagnetic radiations (IE) ranges from 1,000 to 3,500nm, preferably from 1,100 to 1,500nm.

18. A separation assembly comprising:

- a separation stack according to one of claims 10 to 17,
- a device so arranged as to expose the separating layer(s) (3) to electromagnetic radiations (IE) via the substrate (2) for an exposure time at a given power density so that the separating layer(s) (3) decompose(s) under the effect of heat resulting from the absorption of said electromagnetic radiations (IE), with the device preferably comprising a laser emitting said electromagnetic radiations (IE) associated with an optical parametric oscillator.

1

4

3

5

2

IE

**Fig 1**

**EP 3 031 074 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100255344 A
- US 20020068201 A1